# EUROPEAN PATENT APPLICATION

(11) **EP 4 838 233 A1**
(43) Date of publication of application: **11.11.2026**
(21) Application number: 26175781.9
(22) Date of filing: 30.04.2026
(51) Int. Cl.: G01R 31/12, G01R 31/50, G01R 31/52

(54) **INSULATION PEELING ROLL ASSEMBLY FOR EFFICIENT ELECTRICAL QUALITY TESTS**

(30) Priority: 09.05.2025 NO 20250520
(71) Applicant: Nexans, 92400 Courbevoie (FR)
(72) Inventor: DOEDENS, Espen, 1788 Halden (NO); JARVID, Erik Markus, 44242 Kungälv (SE)
(74) Representative: Acapo Onsagers AS

(57) **Abstract**

The present invention relates to a measurement assembly comprising a layered structure being rolled up and a method of manufacturing the measurement assembly. Further, the present invention relates to a method of measurement using the measurement assembly and the use of the measurement assembly. The measurement assembly is used for an efficient electrical quality test.

## Description

### FIELD OF THE INVENTION

The present invention relates electrical quality tests of the insulation materials used for high-voltage cables or medium voltage cables. In particular, the present invention relates to a measurement assembly comprising a layered structure being rolled up and a method of manufacturing the measurement assembly. Further, the present invention relates to a method of measurement using the measurement assembly and the use of the measurement assembly. The measurement assembly is used for an efficient and accurate electrical quality test.

### BACKGROUND

As the world shifts towards renewable energy sources like wind and solar power, high-voltage (HV) cables play a vital role in integrating these sources into the grid. They enable the efficient transmission of electricity from remote renewable energy plants to urban centers, reducing reliance on fossil fuels and minimizing environmental impact. The manufacturing of high performance HV power cables became a cornerstone in the field of safe energy supply.

The development of HV power cables requires improvements in material development which again demands test methods for analyzing the materials. The improvement of materials used for manufacturing the HV power cable refers to the insulating materials, in particular, as the voltage increases under which the HV power cables operate. Electrical properties like leakage current are of outstanding importance in the development of HV power cables.

Leakage current measurements are today carried out on cable samples obtained from peeling the insulating material being made of polymeric materials. Such leakage current measurements demand a sophisticated fixture as high voltages of up to 20 kV are used and the circular measurement region is as small as 1,000 mm² and typically below 4,000 mm² as there is a need for a flashover distance between electrodes. Further, there is in practice the need for a guard ring, and even more the width of the peeling is limited. It follows a limited surface area which again results in very low leakage currents during measurement. The very low leakage currents down to the pico-ampere range render the measurement of DC currents to be a challenge, especially at low fields and low temperatures.

The invention solves at least one of the following objects depending on its specific embodiment: An object of the present invention is to provide a measurement assembly enabling an improved reliability and accuracy of the measurement of electrical properties of the material of the insulation layer of HV power cables with. A further object of the present invention is to provide a simple method of manufacturing of the measurement assembly. Even further, the object of the present invention is to provide an improved method of measuring electrical properties of insulation materials of HV power cables. Improvements relate to reliability and accuracy especially at low fields and low temperatures.

### SUMMARY OF THE INVENTION

The invention's underlying problems are solved by the subject matter of claim 1. A first aspect of the invention therefore relates to a measurement assembly comprising a layered structure being rolled up which layered structure comprises a first electrode, a peeling sample, a second electrode, and an insulating layer.

The measurement assembly according to the invention requires a layered structure being rolled up. A person skilled in the art understands the meaning of a layered structure being rolled up. It refers preferably to a construction comprising distinguishing layers being assembled each on top of one another, wherein the layered structure is then rolled up by starting from one edge of the layered structure and rolling the layered structure to obtain a body having a cylindrical shape.

The layered structure comprises at least four layers, i.e. a first electrode, a peeling sample, a second electrode, and an insulating layer.

The peeling sample is the layer of interest, i.e. the layer of which electrical property or properties is/are to be analyzed.

In a conventional set-up, a peeling layer is sandwiched between a first electrode and a second electrode in a planar architecture. Such a conventional set-up is associated with the above-mentioned disadvantage that the overall area is too small. When measuring the leakage current through insulation materials tested at a peeling layer, there is a demand of a sophisticated fixture as voltages of up to 20 kV are required for a reliable measurement. At such voltages, there is a need for a flashover distance between electrodes. The flashover distance is known by a skilled person which is also called the strike distance: In high voltage applications, the term flashover distance refers to the shortest path through air (or another insulating medium) between two conductive parts at different electrical potentials where a flashover (or electrical discharge) can occur. It can mean the shortest distance between the end fittings of the insulator in the surrounding medium. The electrodes in a conventional measurement architecture must be arranged in relation to the peeling sample such that the flashover is avoided. This limits in practice the dimension of a measurement assembly.

Further, there is in practice the need for a guard ring, and even more the width of the peeling is limited. It follows a limited surface area which again results in very low leakage currents during measurement. The very low leakage currents down to the pico-ampere range render the measurement of DC currents to be a challenge, especially at low fields and low temperatures.

The invention solves these problems i.a. by the rolling-up of the layered architecture. However, a simple rolling-up would result in the fact that the electrodes would contact one another. In order to prevent this effect, the insulating layer is part of the layered architecture.

The measurement assembly enables measurements at elevated temperatures, or elevated fields. In particular, low field measurements are made simpler.

In one aspect, the layered structure has the order or the reversed order following the sequence of the first electrode, the peeling sample, the second electrode, and the insulating layer.

The order of the layered structure is compelling due to the function of the layers. For instance, a person skilled in the art will of course immediately understand that the electrodes cannot be adjacent to one another, and also the layer of interest must be between the electrodes.

In one aspect, the layered structure being rolled up forms a cylindrical geometry.

The rolling up of the layered structure results in the cylindrical geometry. When rolling up the layered structure, the ending edge will appear at the outer portion of the cylinder. For that reason, this geometry does not necessarily form a perfect cylinder, but a cylinder with some deviations.

In one aspect, the insulating layer is a second peeling sample, and/or a polymer insulating layer.

The insulating layer has the function of separating the first electrode and the second electrode. Therefore, according to one aspect, the insulating layer consists of a layer having electrical insulating properties. Thus, the insulating layer may be a polymer insulating layer. A layer having electrical insulating properties have an electrical resistance value of at least 2 Megaohm (MΩ), preferably 3 to 50 MΩ, more preferred 5 to 20 MΩ. However, the insulating layer may consist of a second peeling sample. The measurement is thus performed between the first electrode and the second electrode as well as between the second electrode and the first electrode. Further, in one aspect, the insulating layer may be the second peeling sample and the polymer insulating layer. In this aspect, both layers may be present in any order of sequence. A person skilled in the art understands how to analyze the electrical property of the peeling sample and the second peeling sample. It is a preferred aspect, where the insulating layer consists of the second peeling sample. This enables the measurement of a larger specimen to be analyzed.

In one aspect, the measurement assembly comprises a guard element at a ground electrode.

This aspect enables the deduction of surface currents from the measured current. For the construction of the guard element, it is arranged at the peeling sample, if present also at the second peeling sample, such that the guard element is not in contact with the first electrode and the second electrode. The function of the guard element determines its arrangement.

In one aspect, the peeling sample is a peeling sample of a high voltage cable, preferably a peeling sample of an insulation layer of a high voltage cable. In a further aspect of the power cable, the cable is designed for voltages of 100 kV or higher, 320 kV or higher, or 525 kV or higher.

In a further alternative, the peeling sample is a peeling sample of a medium voltage cable. The smallest dimension of power cables, which insulation layer is analyzed, amounts to 95mm² in cross section with insulation thickness of 4 mm to 5 mm.

In one aspect, the measurement assembly further comprises at least one or more of the following:
a tab for connecting the first electrode and/or second electrode with an external circuit;
a casing enclosing the measurement sample in its cylindrical geometry.

In the framework of the present application, a tab is understood as a thin, conductive strip that connects the internal components of the measurement assembly to its external circuits. Tabs are used to conduct current from the electrode (e.g. in a battery, capacitor, or other electrochemical device) to the external terminals or circuitry.

The casing ensures protection of the peeling sample from the environment and in the course of the sample handling. The casing is optional, i.e. it is not required. However, it is associated with a convenient way of performing measurements.

The invention's underlying problems are solved by the subject-matter of claim 8. A second aspect of the invention therefore relates to a method of manufacturing a measurement assembly according to the first aspect of the invention, wherein the method comprises the steps of
- providing the layered structure comprising the first electrode, the peeling sample, the second electrode, and the insulating layer; and
- rolling the layered structure to obtain a cylindrical geometry measurement sample, wherein the step of providing the layered structure comprises the provision of the first electrode (11) and/or the second electrode (12) obtained by depositing an electrically conductive material on the peeling sample, wherein the deposition of the electrically conductive material is performed by sputter coating or painting.

This method results in obtaining a measurement assembly according to the first aspect of the invention. The method renders clear what is meant by the feature of claim 1 according to which the layered structure is rolled-up.

In one aspect, the method further comprises the step of providing the layered structure comprises the provision of the first electrode and/or the second electrode obtained by depositing an electrically conductive material, preferably a metal or carbon black, on the peeling sample.

The material of the electrodes is chosen from an electrically conductive material. It may be metal or carbon black. There are different ways of introducing the electrodes into the measurement assembly.

In a preferred aspect, the deposition of the electrically conductive material is performed by sputter coating or painting.

These methods of deposition ensure a close contact of the first electrode and second electrode with the peeling sample. Further, they are associated with a simple way of manufacturing.

In one aspect, the step of providing the layered structure comprises the provision (a) metal foil(s) as the first electrode and/or the second electrode by arranging the metal foil(s) adjacent to the peeling sample; and wherein the step of rolling the layered structure is performed after the step of providing the layered structure. Again, if metal foil(s) is/are used, the surface of the peeling sample is, according to a preferred aspect, not provided with a coated or sputtered layer of a conductive material.

The use of metal foil(s) together with sputter coated metal or painting a conductor tape is less preferred but one option. It is preferred to either coat or paint the conductive material or to use metal foils into the roll assembly.

In one aspect of the measurement assembly, where the insulating layer is the peeling layer, the method of manufacturing comprises the step of folding the peeling layer around the first electrode or the second electrode. The layered structure comprises, in thickness direction, the peeling layer, the first electrode, the peeling layer, and the second electrode. In this case, the peeling layer turns around the first electrode or the second electrode. In other words, the peeling layer is looped around the first electrode or the second electrode.

The invention's underlying problems are solved by the subject-matter of claim 12. A third aspect of the invention therefore relates to a method of measurement using the measurement assembly according to the first aspect of the invention, wherein the method comprises measuring an electrical property of the peeling sample, wherein the electrical property is the leakage current.

In this method, the measurement assembly is used for the measurement. It is immediately obvious for a skilled person that the actual measurement requires a connection between the first electrode and second electrode with a voltage supply. A person skilled in the art knows how to connect the measurement assembly with a voltage source and measurement instruments for detecting the electrical parameters.

In one aspect, the method comprises applying a DC potential on one of the first electrode or the second electrode; preferably applying a potential difference between the first electrode and the second electrode. The potential difference between the first electrode and the second electrode is preferably from 1 V to 20 kV, more preferred from 500 V to 10 kV, even more preferred from 1 kV to 5 kV.

By applying such potential difference, the electrical breakdown, leakage current and/or the dielectric response can be measured. It is the architecture of the measurement assembly which enables the measurement of these electrical properties in higher accuracy, higher reliability and under various measurement conditions. Especially the measurement at lower voltages results in more accurate measurements.

In one aspect, the method of measurement comprises soaking the peeling layer with a liquid. In this preferred method, the compatibility of a liquid with the material forming the insulation layer of the HV power cable can be tested. In particular, this preferred method tests the compatibility of certain liquids with the insulation layer of the HV power cable. In such case, the step of soaking the liquid is preferably performed before rolling the assembly together.

The invention's underlying problems are solved by the subject-matter of claim 13. A fourth aspect of the invention therefore relates to the use of a measurement assembly according to the first aspect of the invention which use is for measuring an electrical property of the peeling sample.

As for preferred electrical properties of the peeling sample being measured, the electrical breakdown, the leakage current and/or the dielectric response is disclosed herewith.

Features being solely disclosed in connection with regard to the device of the invention, i.e. with regard to the measurement assembly, are deemed to be disclosed in connection with the methods of the invention, i.e. the method of manufacturing the measurement assembly the invention and the method of measuring according to the invention, and vice versa.

Further, features being solely disclosed in connection with the device of the invention, i.e. with regard to the measurement assembly, are deemed to be disclosed in connection with the use of the invention and vice versa.

### BRIEF DESCRIPTION OF DRAWINGS

Fig. 1 schematically illustrates the measurement assembly in a rolled-up fashion showing the layered structure.
Fig. 2 schematically illustrates the measurement assembly which rolled-up layered structure is contained in a casing.

### DETAILED DESCRIPTION

In the following description, examples and embodiments of the invention are set forth in order to provide the skilled person with a more thorough understanding of the invention. The specific details described in the context of the various embodiments and with reference to the attached drawings are not intended to be construed as limitations.

### Definitions:

The term "measurement assembly" is well known in the art. It represents a set up being used for a measurement. The parameters to be analyzed according to the present application concern the peeling sample. The parameters are electrical properties of the peeling sample.

The term "high voltage" as applied herein refers to a voltage above 36 kV (IEC terms > 36 kV) such as in the range 50 kV to 800 kV. The term "medium voltage" as applied herein refers to voltages from 1 kV to 36 kV.

The term "insulating layer" concerns the layer included in the layered architecture. The term "insulation layer" refers to the layer of a high voltage cable surrounding the metal conductor.

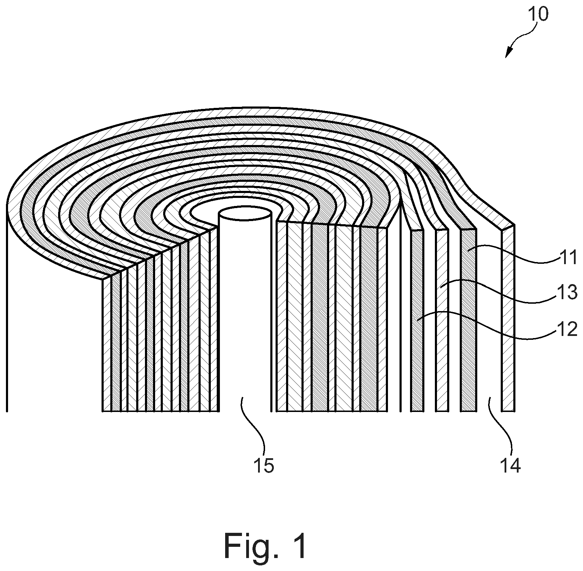

Fig. 1 shows a rolled-up layered structure 10 with its essential features of the first electrode 11, second electrode 12, peeling sample 13, and insulating layer 14. The order of the layers is determined by its function: The peeling sample 13 is sandwiched between the first electrode 11 and the second electrode 12. For the reason of electrically separating the first electrode 11 from the second electrode 12 when rolling up the layered structure, there is provided the insulating layer 14 as separation layer between the first electrode 11 and the second electrode 12 on the other side of the electrodes relative to the peeling sample 13.

In a preferred embodiment, the insulation layer 14 may be the peeling sample 13.

The peeling sample 13 is obtained from the insulation layer of a high voltage cable by using a peeling step known to a person skilled in the art.

According to a preferred aspect of the invention, the peeling sample 13 can be provided with a first electrode 11 on one side of the peeling sample 13 and the second electrode 12 on the other side of the peeling sample 13, wherein both provisions of the first electrode 11 and the second electrode 12 is performed by sputtering according to this preferred aspect.

Then an insulating layer 14, which can be a second peeling sample 14 according to a preferred embodiment, is attached to the assembly of first electrode 11, peeling sample 13, and second electrode 12. This assembly comprising the four essential layers of the layered structure is then rolled-up. The attaching of the electrodes can either mean that the electrodes are assembled with the further layers or it can mean that the are fixed by a medium with the adjacent layer.

The step of rolling up can be performed by using a core element 15 being the center of the rolled-up layered structure. In a preferred aspect, the core element 15 may work as a tab having contact to one of the first electrode 11 or second electrode 12.

For being usable as a measurement assembly, the first electrode 11 and second electrode 12 are electrically connected, e.g. by using a tab, to an exterior part of the measurement assembly 20 for enabling a connection to further gadgets enabling the actual measurement.

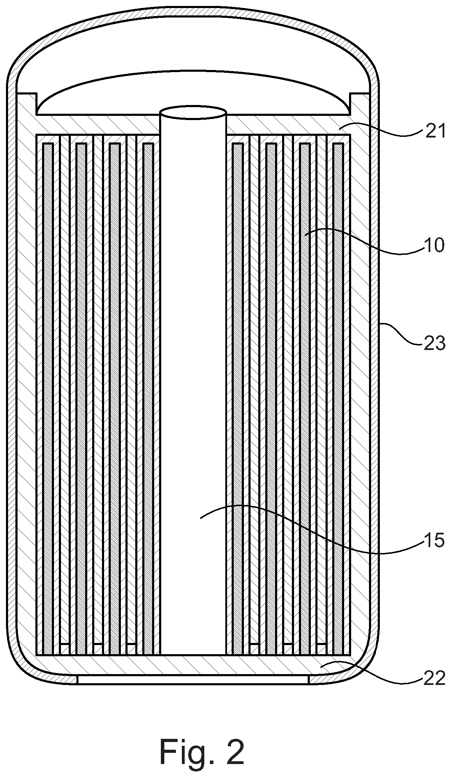

Fig. 2 shows the measurement assembly 20 comprising the rolled-up layered structure 10 in a casing 23. It is acknowledged that the essential features of the invention refer to the rolled-up layered structure 10. The casing 23 is an optional feature of the measurement assembly 20.

The following item show specific embodiment of the invention:
1. Measurement assembly (20) comprising a layered structure being rolled up (10) which layered structure comprises a first electrode (11), a peeling sample (13), a second electrode (12), and an insulating layer (14).
2. Measurement assembly (20) according to claim 1, wherein the layered structure has the order or the reversed order following the sequence of the first electrode (11), the peeling sample (13), the second electrode (12), and the insulating layer (14).
3. Measurement assembly (20) according to claim 1 or claim 2, wherein the layered structure being rolled up (10) forms a cylindrical geometry.
4. Measurement assembly (20) according to any one of claims 1 to 3, wherein the insulating layer (14) is a second peeling sample (13), and/or a polymer insulating layer.
5. Measurement assembly (20) according to any one of claims 1 to 4, wherein the measurement assembly (20) comprises a guard element at a ground electrode.
6. Measurement assembly according to any one of claims 1 to 5, wherein the peeling sample (13) is a peeling sample (13) of a high voltage cable, preferably a peeling sample (13) of an insulation layer of a high voltage cable.
7. Measurement assembly (20) according to any one of claims 1 to 6, wherein the measurement assembly (20) further comprises at least one or more of the following:
   - a tab for connecting the first electrode and/or second electrode with an external circuit;
   - a casing enclosing the measurement sample in its cylindrical geometry.
8. Method of manufacturing a measurement assembly (20) according to any one of claims 1 to 8, wherein the method comprises the steps of
   - providing the layered structure comprising the first electrode **(11),** the peeling sample (13), the second electrode (12), and the insulating layer (14); and
   - rolling the layered structure to obtain a cylindrical geometry.
9. Method of manufacturing a measurement assembly (20) according to claim 9, wherein the step of providing the layered structure comprises the provision of the first electrode (11) and/or the second electrode (12) obtained by depositing an electrically conductive material, preferably a metal or carbon black, on the peeling sample.
10. Method of manufacturing a measurement assembly (20) according to claim 9, wherein the deposition of the electrically conductive material is performed by sputter coating or painting.
11. Method of manufacturing a measurement assembly (20) according to claim 9, wherein step of providing the layered structure comprises the provision (a) metal foil(s) as the first electrode (11) and/or the second electrode (12) by arranging the metal foil(s) adjacent to the peeling sample (13); and wherein the step of rolling the layered structure is performed after the step of providing the layered structure.
12. Method of measurement using the measurement assembly (20) according to any one of claims 1 to 7, wherein the method comprises measuring an electrical property of the peeling sample (13).
13. Method of measurement according to claim 12, wherein the method comprises applying a DC potential on one of the first electrode **(11)** or the second electrode (12) ; preferably applying a potential difference between the first electrode (11) and the second electrode (12), wherein more preferred the potential difference is from 1 V to 20 kV, preferably from 500 V to 10 kV, more preferred from 1 kV to 5 kV.
14. Use of a measurement assembly (20) according to any one of claims 1 to 7 for measuring an electrical property of the peeling sample (13).

### REFERENCE LIST

- 10: Rolled-up layered structure
- 11: First electrode
- 12: Second electrode
- 13: Peeling sample or second peeling sample
- 14: Insulating layer
- 15: Core element
- 20: Measurement assembly
- 21: Positive electrode collector
- 22: Negative electrode collector
- 23: Casing

## Claims

1. Measurement assembly (20) comprising a layered structure being rolled up (10) which layered structure comprises a first electrode (11), a peeling sample (13), a second electrode (12), and an insulating layer (14).

2. Measurement assembly (20) according to claim 1, wherein the layered structure has the order or the reversed order following the sequence of the first electrode (11), the peeling sample (13), the second electrode (12), and the insulating layer (14).

3. Measurement assembly (20) according to claim 1 or claim 2, wherein the layered structure being rolled up (10) forms a cylindrical geometry.

4. Measurement assembly (20) according to any one of claims 1 to 3, wherein the insulating layer (14) is a second peeling sample (13), and/or a polymer insulating layer.

5. Measurement assembly (20) according to any one of claims 1 to 4, wherein the measurement assembly (20) comprises a guard element at a ground electrode.

6. Measurement assembly according to any one of claims 1 to 5, wherein the peeling sample (13) is a peeling sample (13) of a high voltage cable, preferably a peeling sample (13) of an insulation layer of a high voltage cable.

7. Measurement assembly (20) according to any one of claims 1 to 6, wherein the measurement assembly (20) further comprises at least one or more of the following:
• a tab for connecting the first electrode and/or second electrode with an external circuit;
• a casing enclosing the measurement sample in its cylindrical geometry.

8. Method of manufacturing a measurement assembly (20) according to any one of claims 1 to 7, wherein the method comprises the steps of
• providing the layered structure comprising the first electrode (11), the peeling sample (13), the second electrode (12), and the insulating layer (14); and
• rolling the layered structure to obtain a cylindrical geometry, wherein the step of providing the layered structure comprises the provision of the first electrode (11) and/or the second electrode (12) obtained by depositing an electrically conductive material on the peeling sample, wherein the deposition of the electrically conductive material is performed by sputter coating or painting.

9. Method of manufacturing a measurement assembly (20) according to claim 8, wherein the step of providing the layered structure comprises the provision of the first electrode (11) and/or the second electrode (12) obtained by depositing an electrically conductive material, being a metal or carbon black, on the peeling sample.

10. Method of manufacturing a measurement assembly (20) according to claim 9, wherein step of providing the layered structure comprises the provision (a) metal foil(s) as the first electrode (11) and/or the second electrode (12) by arranging the metal foil(s) adjacent to the peeling sample (13); and wherein the step of rolling the layered structure is performed after the step of providing the layered structure.

11. Method of measurement using the measurement assembly (20) according to any one of claims 1 to 7, wherein the method comprises measuring an electrical property of the peeling sample (13), wherein the electrical property is the leakage current.

12. Method of measurement according to claim 11, wherein the method comprises applying a DC potential on one of the first electrode (11) or the second electrode (12) ; preferably applying a potential difference between the first electrode (11) and the second electrode (12), wherein more preferred the potential difference is from 1 V to 20 kV, preferably from 500 V to 10 kV, more preferred from 1 kV to 5 kV.

13. Use of a measurement assembly (20) according to any one of claims 1 to 7 for measuring an electrical property of the peeling sample (13).
